# EUROPÄISCHE PATENTSCHRIFT

(11) **EP 3 737 951 B1**
(45) Veröffentlichungstag und Bekanntmachung des Hinweises auf die Patenterteilung: **20.10.2021**
(21) Anmeldenummer: 19714120.3
(22) Anmeldetag: 12.03.2019
(51) Int. Cl.: G01R 15/18

(54) **VERFAHREN UND EINRICHTUNG ZUR MESSUNG EINES WECHSELSTROMS MIT EINEM ROGOWSKI-STROMWANDLER**
METHOD AND DEVICE FOR MEASURING AN ALTERNATING CURRENT WITH A ROGOWSKI CURRENT TRANSFORMER
PROCÉDÉ ET DISPOSITIF POUR MESURER UN COURANT ALTERNATIF AVEC UN TRANSFORMATEUR DE COURANT ROGOWSKI

(30) Priorität: 19.03.2018 DE 102018204129
(43) Veröffentlichungstag der Anmeldung: 18.11.2020
(73) Patentinhaber: Siemens Aktiengesellschaft, 80333 München (DE)
(72) Erfinder: GRZEGANEK, Andreas, 04703 Leisnig (DE); WOLFF, Sebastian, 33428 Harsewinkel (DE)
(86) Internationale Anmeldenummer: PCT/EP2019/056145
(87) Internationale Veröffentlichungsnummer: WO 2019/179825

(56) Entgegenhaltungen:
- DE-A1-102012 107 021

## Beschreibung

Die Erfindung betrifft ein Verfahren und eine Einrichtung zur Messung eines Wechselstroms mit einem Rogowski-Stromwandler gemäß den Oberbegriffen der Ansprüche 1 und 7.

Verfahren und Einrichtungen zur Messung eines elektrischen Wechselstroms in Nieder- und Mittelspannungsschaltanlagen sind bekannt. Insbesondere werden dazu Stromwandler verwendet, die eine sogenannte Rogowskispule aufweisen, d.h. eine toroidförmige Luftspule.

Die Rogowskispule besteht aus einem Leiterdraht, der gleichmäßig um einen festen Körper gewickelt ist, der keine permeablen Kernmaterialien aufweist, so dass keine Wandlersättigung auftreten kann. Die Rogowskispule kann zudem sehr kompakt ausgeführt sein und stellt eine galvanische Trennung des Messkreises vom Stromkreis der Energieversorgung sicher.

Umschließt die Rogowskispule einen Wechselstrom führenden Stromleiter (Strompfad) vollständig, wird als Ausgangsgröße jeweils eine Spannung erzeugt, die proportional zur ersten Ableitung des Wechselstroms nach der Zeit ist. Es ist also erforderlich, die so erzeugte Spannung zu integrieren, um die gewünschte Proportionalität des Ausgangssignals des Wandlers zum zu messenden Wechselstrom zu erreichen.

Die bei der Verwendung von Rogowskispulen notwendige Integration erfolgt nach dem Stand der Technik entweder durch einen analogen Tiefpass mit unterschiedlichen Kompensationsschaltungen oder wird mittels ASIC's oder FPGA's realisiert.

Führt man die Integration mittels eines analogen Integrators in Form eines Tiefpasses aus, sind die auftretenden Winkelfehler auf Grund des Frequenzgangs frequenzabhängig. Deshalb erfolgt die Dimensionierung des analogen Integrators üblicherweise so, dass der Winkelfehler bei der gewünschten Grundfrequenz (50 oder 60 Hz) annähernd 0° beträgt. Aber auch der durch den analogen Integrator verursachte Amplitudenfehler ist frequenzabhängig. Die Dimensionierung des Gesamtverstärkungsfaktors des analogen Integrators erfolgt deshalb üblicherweise so, dass auch der Amplitudenfehler bei der gewünschten Grundfrequenz annähernd 0% beträgt. Neben dem frequenzabhängigen Winkel- und Amplitudenfehler weisen analoge Integratoren auch noch ein unerwünschtes deutliches Einschwingverhalten auf.

Eine digitale numerische Integration mittels integrierten Schaltkreisen der Digitaltechnik in Form eines FPGA (Field Programmable Gate Array) oder anwendungsspezifischer in Form eines ASIC (Application Specific Integrated Circuit) ist prinzipiell in der Lage, die vorstehend beschriebenen Nachteile analoger Integratoren zu großen Teilen zu vermeiden, da der Winkelfehler nur noch von der Signallaufzeit abhängig ist. Die Winkelfehler, welche durch die Signallaufzeit bedingt sind, können im Vergleich mit dem maximal zulässigen Wert, der für Schutz- und Messwandler zur Strommessung in Nieder- und Mittelspannungsschaltanlagen in den einschlägigen Normen festgelegt ist, im Allgemeinen vernachlässigt werden.

ASIC- oder FPGA-basierte Integratoren verursachen allerdings einen relativ hohen Schaltungsaufwand und damit verbundene Kosten, insbesondere auch für deren Entwicklung.

Führt man die Integration mit einem Mikrocontroller (oder Mikroprozessor) durch, ergibt sich als Nachteil ebenfalls ein Zeitverzug, der durch die Laufzeit zwischen dem von der Rogowskispule erfassten Stromsignal und dem vom Mikrocontroller berechneten Ausgangssignal bedingt ist. Dieser Zeitverzug führt zu einem Winkelfehler, der größer als der maximal zulässige Wert ist.

Die für eine hinreichend genaue Messung erforderliche Pegelanpassung des Ausgangsignals der Rogowskispule an die Referenzspannung der AD-Wandlung des Mikrocontrollers verursacht dabei zusätzlich eine Offset-Spannung, welche die Realisierung der geforderten Messgenauigkeit verhindern kann. Der Grund für die Pegelanpassung liegt auch darin begründet, dass die auftretenden Ströme in ihrer Höhe stark variieren können.

Unabhängig von der Art des Stromwandlers kommt es bei räumlicher Nähe zu einem Strompfad, der von einem hohen Strom durchflossen ist und vom Stromwandler nicht erfasst werden soll, zum sogenannten Übersprechen, d.h. der Pegel des Ausgangssignals des Stromwandlers wird durch das magnetische Feld des Stroms in unmittelbarer Nähe des Stromwandlers beeinflusst. Dieser Pegel wird dem eigentlichen Messpegel überlagert und verfälscht das Ergebnis der Messung.

Das Übersprechen durch benachbarte hohe Ströme verringert man, indem für die verwendeten Wandler Einbauvorschriften existieren, die einen Mindestabstand in Abhängigkeit von der Höhe der benachbarten Ströme erfordern. Insbesondere in Niederspannungsschaltanlagen lassen sich diese Forderungen nur mit hohem Aufwand realisieren.

Im Fall der Verwendung von Rogowskispulen lässt sich dieser Effekt deutlich reduzieren, wenn diese hinreichend exakt gewickelt sind, was spezielle Verfahren und Maschinen erfordert.

Die DE 10 2012 107 021 A1 beschreibt ein Verfahren zur Messung eines Wechselstroms mittels einer Rogowskispule, die einen Strompfad umschließt, durch den der zu messende Wechselstrom fließt, der periodisch kontinuierliche Stromwerte durchläuft und zu einem ersten Zeitpunkt einen aktuellen Stromwert annimmt, bei dem die Rogowskispule jeweils eine korrespondierende erste analoge Wechselspannung erzeugt, bei dem die erste analoge Wechselspannung in korrespondierende digitale Spannungswerte umgewandelt wird, die zeitlich fortlaufend aufeinanderfolgen, wobei der zum ersten Zeitpunkt gehörende digitale Spannungswert als aktueller erster Spannungswert ausgegeben wird, und bei dem der aktuelle erste Spannungswert jeweils entsprechend dem Vorzeichen der ersten analogen Wechselspannung entweder mit einem positiven oder einem negativen Vorzeichen versehen wird.

Die Aufgabe der Erfindung ist es, ein Verfahren und eine Einrichtung zur Messung eines Wechselstroms mit einem Stromwandler mit einer Rogowskispule vorzuschlagen, wobei die Messung mit relativ geringem Schaltungsaufwand über einen großen Strombereich nur einen geringen Phasenfehler aufweist.

Die Lösung sieht bezogen auf das Verfahren vor, dass a) der aktuelle erste Spannungswert der Ausgangsspannung der Rogowskispule jeweils zu einem ersten Summenwert hinzuaddiert und so jeweils ein aktueller erster Summenwert gebildet wird, b) jeweils aus den fortlaufend aufeinanderfolgenden (aufeinanderfolgend gebildeten) ersten Summenwerten ein aktueller gleitender erster Mittelwert gebildet, dieser vom ersten Summenwert abgezogen und so ein aktueller zweiter Summenwert gebildet wird, c) jeweils aus den fortlaufend aufeinanderfolgenden (aufeinanderfolgend gebildeten) zweiten Summenwerten ein aktueller gleitender zweiter Mittelwert gebildet, dieser vom aktuellen zweiten Summenwert abgezogen und so ein aktueller dritter Summenwert gebildet wird, d) mehrere dritte Summenwerte verwendet werden, um durch Extrapolation (extrapolierend) einen aktuellen Vorhersagewert für einen vorgegebenen Ausgabezeitpunkt zu berechnen, (der zeitlich hinter dem ersten Zeitpunkt liegt, und e) der aktuelle Vorhersagewert jeweils zu dem vorgegebenen Ausgabezeitpunkt ausgegeben wird und aus den fortlaufend aufeinanderfolgenden Vorhersagewerten eine zweite analoge Wechselspannung gebildet wird.

Technisch einfach ist es, wenn der aktuelle Vorhersagewert anhand der Änderung des aktuellen dritten Summenwerts gegenüber dem unmittelbar vorhergehenden dritten Summenwert und dem aktuellen dritten Summenwert berechnet wird.

Das Verfahren lässt sich weiter vereinfachen, wenn der aktuelle Vorhersagewert berechnet wird, indem die Änderung des aktuellen dritten Summenwerts gegenüber dem unmittelbar vorhergehenden dritten Summenwert anteilig zum berechneten aktuellen dritten Summenwert hinzuaddiert wird.

Die Genauigkeit lässt sich erhöhen, wenn die zweite analoge Wechselspannung verstärkt und ein Offset der verstärkten zweiten analogen Wechselspannung durch eine entsprechende Korrektur des jeweils aktuellen Vorhersagewerts berücksichtigt (abgezogen) wird.

Änderungen des Offsets lassen sich einfach berücksichtigen, indem die verstärkte zweite analoge Wechselspannung digitalisiert und ein dritter Mittelwert als Offset der zweiten analogen Wechselspannung berechnet und für eine entsprechende Korrektur des jeweils aktuellen Vorhersagewerts verwendet (abgezogen) wird.

Die Offsetkorrektur verbessert sich, wenn die verstärkte zweite analoge Wechselspannung vor der Digitalisierung ein weiteres Mal verstärkt wird und ein gleitender dritter Mittelwert der zweifach verstärkten zweiten analoge Wechselspannung als Offset der zweiten analogen Wechselspannung berechnet und für eine entsprechende Korrektur des jeweils aktuellen Vorhersagewerts verwendet (abgezogen) wird.

Zweckmäßigerweise werden der aktuelle gleitende erste Mittelwert jeweils aus unmittelbar aufeinanderfolgenden ersten Summenwerten einschließlich des aktuellen ersten Summenwerts und der aktuelle gleitende zweite Mittelwert jeweils aus unmittelbar aufeinanderfolgenden zweiten Summenwerten einschließlich des aktuellen zweiten Summenwerts gebildet.

Von Vorteil ist es weiter, wenn der aktuelle gleitende erste Mittelwert aus einer festen ersten Anzahl fortlaufend aufeinanderfolgender erster Summenwerte gebildet wird, wobei sich die Anzahl jeweils über mehrere Schwingungsdauern erstreckt (gemittelt wird), und dass der aktuelle gleitende zweite Mittelwert aus einer festen zweiten Anzahl fortlaufend aufeinanderfolgender zweiter Summenwerte gebildet wird, wobei sich die Anzahl jeweils über mehrere Schwingungsdauern erstreckt (gemittelt wird).

Die Lösung sieht bezogen auf die Einrichtung vor, dass zur Weiterverarbeitung der Ausgangsgröße der Rogowskispule nach einem Operationsverstärker und einem AD-Wandler eine Recheneinrichtung vorgesehen ist, welche den vorzeichenbehafteten aktuellen ersten Spannungswert jeweils zu einem ersten Summenwert hinzuaddiert und so jeweils einen aktuellen ersten Summenwert bildet, welche aus den fortlaufend aufeinanderfolgend gebildeten ersten Summenwerten einen aktuellen gleitenden ersten Mittelwert bildet, diesen jeweils vom aktuellen ersten Summenwert abzieht und so jeweils einen aktuellen zweiten Summenwert bildet, welche aus den fortlaufend aufeinanderfolgend gebildeten zweiten Summenwerten einen aktuellen gleitenden zweiten Mittelwert bildet, diesen jeweils vom aktuellen zweiten Summenwert abzieht und so jeweils einen aktuellen dritten Summenwert bildet, welche aus einem oder mehreren dritten Summenwerten einen aktuellen Vorhersagewert durch Extrapolation für einen vorgegebenen Ausgabezeitpunkt berechnet, der zeitlich hinter dem ersten Zeitpunkt liegt. Ein DA-Wandler bildet anschließend den aktuellen Vorhersagewert als letzten Wert der fortlaufend aufeinanderfolgenden Vorhersagewerte zu dem vorgegebenen Ausgabezeitpunkt als zweite analoge Wechselspannung aus.

Zweckmäßig ist es, wenn ein zweiter Verstärker vorhanden ist, der an den zweiten AD-Wandler angeschlossen ist, und dass die Recheneinrichtung im Falle eines vom zweiten Verstärker verursachten Offsets diesen Offset jeweils vom aktuellen Vorhersagewert abzieht.

Eine verbesserte Offsetkorrektur ergibt sich, wenn eine Rückführung vom zweiten Verstärker über, einen zweiten AD-Wandler vorhanden ist, der zur Korrektur des Offsets des zweiten Verstärkers an die Recheneinrichtung angeschlossen ist.

Offsetänderungen lassen sich relativ einfach korrigieren, wenn der zweite AD-Wandler korrespondierende digitale zweite Spannungswerte der Recheneinrichtung zur Verfügung stellt, die fortlaufend aufeinanderfolgende zweite Spannungswerte bilden, aus denen die Recheneinrichtung einen gleitenden dritten Mittelwert als Offset des zweiten Verstärkers berechnet, welchen die Recheneinrichtung jeweils für eine Korrektur des aktuellen Vorhersagewerts verwendet.

Die Erfindung wird nachfolgend anhand eines Ausführungsbeispiels näher beschrieben. Es zeigen:
- Fig. 1: eine schematische Darstellung einer Einrichtung zur Messung eines Wechselstroms mit einem Mikrocontroller,
- Fig. 2: den Mikrocontroller gemäß Fig. 1 mit einer Signalkonditionierung in einer schematischen Darstellung,
- Fig. 3: die Signalkonditionierung gemäß Fig. 2 mit einer Recheneinrichtung in einer schematischen Darstellung,
- Fig. 4: den Verlauf des aktuellen ersten Summenwerts und Mittelwerts über der Zeit einschließlich der Offset-Stabilisierung,
- Fig. 5: den Verlauf des Wechselstroms und den treppenförmigen Verlauf der analogen Wechselspannung nur mit Offset-Stabilisierung und erster Off-set-Kompensation,
- Fig. 6: den Verlauf des Wechselstroms und den treppenförmigen Verlauf der analogen Wechselspannung mit Offset-Stabilisierung und erster und zweiter Offset-Kompensation,
- Fig. 7: den Verlauf des Wechselstroms und den treppenförmigen Verlauf der analogen Wechselspannung mit Offset-Stabilisierung, erster und zweiter Offset-Kompensation und mit Berechnung der Vorhersagewerte, und
- Fig. 8: die Verfahrensschritte zur Messung des Wechselstroms.

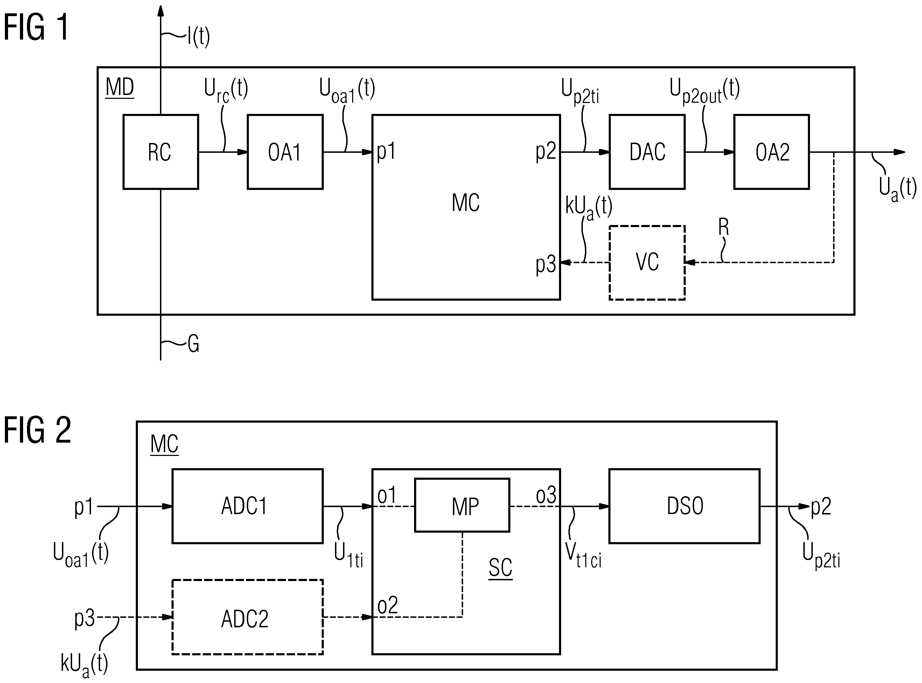

Fig. 1. zeigt in einer schematischen Darstellung eine Einrichtung MD zur Messung eines Wechselstroms I(t), der mit der Zeit t periodisch kontinuierliche Stromwerte durchläuft. Zum besseren Verständnis des Ausführungsbeispiels nimmt der Wechselstrom I(t) zu einem (ersten) Zeitpunkt t0 den aktuellen Stromwert I(t0) und allgemein zum Zeitpunkt ti den Stromwert I(ti) an.

Der Wechselstrom I(t) als Funktion der Zeit t hat eine Grundfrequenz von 50 Hz und fließt durch einen Strompfad in Form eines Stromleiters G, der vollständig von einer Rogowskispule umschlossen ist, die als Ausgangsgröße jeweils korrespondierend zum Wechselstrom I(t) ohne Zeitverzug eine erste analoge Wechselspannung Urc(t) erzeugt, die gleich der ersten Ableitung des Wechselstroms I(t) nach der Zeit t ist: Urc(t)=L*(dI/dt) mit L=Induktivität der Rogowski-Spule RC.

Zur Pegelanpassung ist der Rogowski-Spule RC ein Operationsverstärker OA1 (Operational Amplifier) nachgeschaltet, an dessen Eingang die Wechselspannung Urc(t) und an dessen Ausgang die analoge Wechselspannung Uoa1(t) anliegt, die auf einen Eingang p1 eines Mikrocontrollers MC gegeben wird.

Der Mikrocontroller MC wandelt die am Eingang p1 anliegende analoge Wechselspannung Uoa1(t) in fortlaufend aufeinanderfolgende diskrete erste Spannungswerte U1ti um, wobei ti die diskreten Zeitpunkte einer Folge von äquidistanten, fortlaufend aufeinanderfolgenden digitalen Zeitwerten ti (des kontinuierlichen Zeitverlaufs) sind (mit i = ... -2, -1, 0, 1, 2, 3, 4, ... und so weiter). Die Zeitpunkte ti im analogen Zeitverlauf t entsprechen also jeweils diskreten Zeitwerten ti, werden aber nachfolgend beide als Zeitpunkte ti bezeichnet.

Die Spannungswerte U1ti zu den Zeitpunkten ti liegen dabei jeweils als Digitalzahlen hier beispielhaft mit einer Auflösung von 16 Bit vor. Zu dem Zeitpunkt t0 gehört entsprechend der aktuelle erste Spannungswert U1t0.

Der Buchstabe i ist ein Laufindex, der zur Nummerierung einzelner fortlaufend aufeinanderfolgender digitaler Werte (Zahlenwerte) dient. Dabei gehören hier alle digitalen Werte mit dem gleichen Laufindex i jeweils zu demselben Stromwert I(ti), also alle Werte mit dem Laufindex 0 zum aktuellen Stromwert I(t0) und entsprechend der aktuelle Spannungswert U1t0 zum aktuellen Stromwert I(t0), und zwar unabhängig davon, ob die digitalen Werte mit dem gleichen Laufindex i einen Zeitverzug (eine zeitliche Verzögerung) zueinander oder zum Stromwert I(ti) aufweisen.

Der Spannungswert Urc(ti) ist also der Spannungswert, den der durch die Rogowski-Spule RC fließende Wechselstrom I(t) mit seinem Stromwert I(ti) zum Zeitpunkt ti erzeugt und der von dem nachgeschalteten Operationsverstärker OA1 verstärkt wird, wobei die analoge Wechselspannung Uoa1(t) an dessen Ausgang zum Zeitpunkt ti den Spannungswert Uoa1(ti) aufweist und zur Digitalisierung am Eingang p1 des Mikrocontrollers MC zur Verfügung steht. Dabei verursacht der Operationsverstärker OA1 keinen Zeitverzug, dafür aber einen Offset OFF1, dessen Ursache die bei realen Operationsverstärkern auftretende Offsetspannung ist.

Der Spannungswert U1ti ist also gegenüber dem Spannungswert Urc(ti) mit dem Offset OFF1 behaftet. Zeitlich gesehen liegen der Stromwert I(ti) und der Spannungswert U1ti jeweils zur selben Zeit t vor und es gibt keine Zeitdifferenz.

Nach der Verarbeitung der fortlaufend aufeinanderfolgenden Spannungswerte U1ti gibt der Mikrocontroller MC fortlaufend aufeinanderfolgende Spannungswerte Up2ti an einem Ausgang p2 aus, aus denen der nachgeschaltete DA-Wandler DAC (Digital-Analog Converter) eine zweite analoge Wechselspannung Up2out(t) bildet.

Dem DA-Wandler DAC ist zur Pegelanpassung ein zweiter Operationsverstärker OA2 (Operational Amplifier) nachgeschaltet, so dass am Ausgang der Einrichtung MD eine dritte analoge Wechselspannung Ua(t) als Ausgangsspannung der Einrichtung MD mit dem gewünschten Pegelbereich zur Verfügung steht, wobei die Verarbeitung durch die Einrichtung MD so erfolgt, dass die Wechselspannung Ua(t) amplituden- und phasenmäßig mit dem Strom I(t) übereinstimmt. D.h. die Zeitverläufe der Wechselspannung Ua(t) und des Wechselstroms I(t) stimmen (im Wesentlichen) überein. Anders gesagt: Nach einer Normierung sind die beiden Zeitverläufe des Wechselstroms I(t) und der Wechselspannung Ua(t) (nahezu) identisch.

Außerdem ist beispielhaft eine Rückkopplung R über einen Spannungswandler VC (Voltage Converter) vorhanden, der die analoge Wechselspannung Ua(t) pegelangepasst an einen Eingang p3 des Mikrocontrollers MC gibt, um den Offset OFF2 des Operationsverstärkers OA2 und damit der Wechselspannung Ua(t) zu kompensieren. Die Pegelanpassung ist in Fig. 1 durch k*Ua(t) dargestellt, wobei k ein konstanter Multiplikationsfaktor ist.

Fig. 2 zeigt den Mikrocontroller MC in einer schematischen Darstellung. Der Mikrocontroller MC verfügt über einen AD-Wandler ADC1 (Analog Digital Converter), der eingangsseitig mit dem Eingang p1 des Mikrocontrollers MC verbunden ist.

Die Umwandlung der am Eingang p1 liegenden analogen Wechselspannung Uoa1(t) in die korrespondierenden digitalen Spannungswerte U1ti erfolgt durch den AD-Wandler ADC1. Die fortlaufend aufeinanderfolgenden Spannungswerte U1ti werden an einen Eingang o1 einer Recheneinrichtung MP (z.B. wie hier in Form eines Mikroprozessors) gegeben.

Eine Signalkonditionierung SC (Signal Conditioning) der fortlaufend aufeinanderfolgen Spannungswerte U1ti umfasst im Wesentlichen eine Integration und weitere Verarbeitungsschritte zur Offsetkompensation, um die amplituden- und phasenmäßige Übereinstimmung der Wechselspannung Ua(t) mit dem Wechselstrom I(t) (im Rahmen einer vorgegebenen Genauigkeit) herzustellen.

Nach der Signalkonditionierung SC werden fortlaufend aufeinander folgende Spannungswerte Vtic an der Schnittstelle o3 über eine digitale Ausgabe DSO (Digital Signal Output) an den Ausgang p2 des Mikrocontrollers MC ausgegeben. Hinter der digitalen Ausgabe DSO liegen dann die fortlaufend aufeinanderfolgenden Spannungswerte Up2ti vor.

Am Eingang p3 liegt die rückgekoppelte und bereits pegelangepasste analoge Wechselspannung k*Ua(t) an, die durch den AD-Wandler ADC2 digitalisiert und der Signalkonditionierung SC übergegeben wird, um den Offset OFF2 des Operationsverstärkers OA2 zu kompensieren.

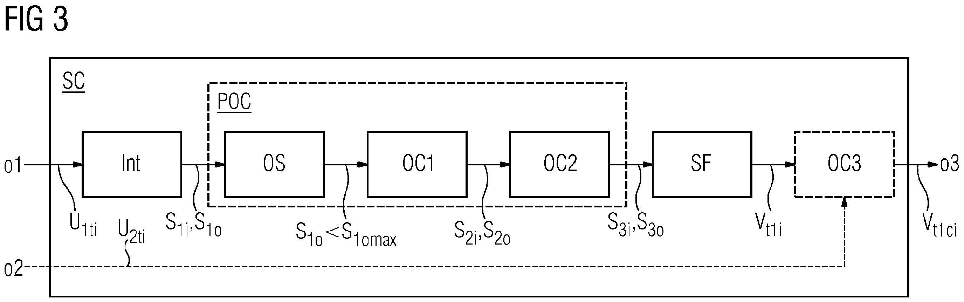

Fig. 3 zeigt die Signalkonditionierung SC durch die Recheneinrichtung MP in einer schematischen Darstellung, in der mittels einer Software (z.B. einer Firmware) die für die Ausgabe an den Eingang p3 erforderliche Signalkonditionierung stattfindet. Dabei müssen die Eingangswerte (U1ti) am Eingang o1 zum einen integriert und zum anderen um die Offsets OFF1 und OFF2 bereinigt werden.

Dazu wird der vom AD-Wandler ADC1 (zeitlich zuletzt) in einer Auflösung von 16 Bit ausgegebene aktuelle Spannungswert U1t0 von der Recheneinrichtung MP jeweils mit dem entsprechenden Vorzeichen versehen, d.h. entsprechend dem Vorzeichen der ersten analogen Wechselspannung Urc(t0) entweder mit einem positiven oder einem negativen Vorzeichen. Der vorzeichenbehaftete aktuelle Spannungswert U1t0 wird zur Ausführung der numerischen Integration Int (Numerical Integration) jeweils zu einem ersten Summenwert Sli hinzuaddiert, der nach der Addition jeweils zum aktuellen ersten Summenwert S10 wird.

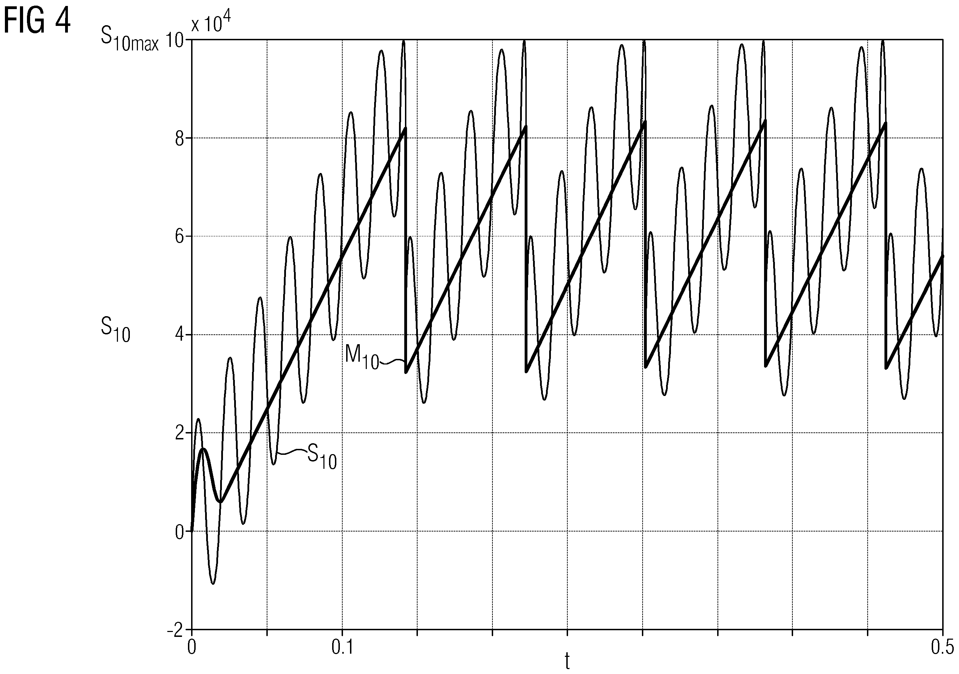

Da die ersten Spannungswerte U1ti eine Auflösung von 16 Bit haben und der Speicher für die Aufsummierung der Summenwerte Sli eine Speichertiefe von 32 Bit hat, ist eine Offset-Stabilisierung OS erforderlich, um zu verhindern, dass der Speicher überläuft. Aus diesem Grunde wird der aktuelle erste Summenwert S10 jeweils nach Erreichen eines vorgegebenen maximalen oberen Summenwerts S10max durch zwei dividiert. Der aktuelle erste Summenwert S10 steigt also jeweils bis zum maximalen oberen Summenwert S10max an, wird dann auf die Hälfte reduziert, steigt dann wieder bis zum maximalen oberen Summenwert S10max an, wird dann auf die Hälfte reduziert, und so weiter (s. Fig. 4).

Die Recheneinrichtung MP der Signalkonditionierung SC speichert jeweils den ersten Summenwert S10 und eine feste erste Anzahl N1 fortlaufend aufeinanderfolgender erster Summenwerte Sli einschließlich des aktuellen ersten Summenwerts S10 als letzten Summenwert dieser ersten Summenwertfolge, also die fortlaufend aufeinanderfolgenden ersten Summenwerte S1-N1+1, S1-N1+2, ... , S1-1, S10. Nur zur Veranschaulichung der Schreibweise: Für N1=5 hätte die erste Summenwertfolge also folgende erste Summenwerte S1i: S1-4, S1-3, S1-2, S1-1, S10 und die beiden nachfolgenden ersten Summenwerte Sli wären dann: S11, S12 (entsprechend dem oben definierten Laufindex i).

Zeitgleich mit der Bildung des aktuellen ersten Summenwerts S10 berechnet die Recheneinrichtung MP zur ersten Offset-Kompensation OC1 einen gleitenden aktuellen ersten Mittelwert M10 aus den jeweils N1 unmittelbar aufeinanderfolgenden ersten Summenwerten Sli einschließlich des aktuellen ersten Summenwerts S10. Die Mittelwertbildung erfolgt jeweils über ein Vielfaches der Zeitdauer einer vollständigen Periode der Grundfrequenz von 50 Hz. Beispielsweise werden N1=600 erste Summenwerte Sli für die Berechnung eines aktuellen ersten Mittelwerts M10 verwendet. Die Recheneinrichtung MP zieht den aktuellen ersten Mittelwert M10 jeweils vom aktuellen ersten Summenwert S10 ab und bildet so jeweils einen aktuellen zweiten Summenwert S20.

Fig. 4 zeigt den Verlauf des aktuellen ersten Summenwerts S10 und des aktuellen ersten Mittelwerts M10 über der Zeit t mit Offset-Stabilisierung OS.

Wie in Fig. 3 weiter gezeigt, führt die Recheneinrichtung MP unmittelbar im Anschluss eine zweite Offset-Kompensation OC2 durch, indem sie einen gleitenden aktuellen zweiten Mittelwert M20 jeweils aus einer festen zweiten Anzahl N2 unmittelbar aufeinanderfolgender zweiter Summenwerte S20 einschließlich des aktuellen zweiten Summenwerts S20 berechnet, wobei die Mittelwertbildung ebenfalls jeweils über ein Vielfaches der Zeitdauer einer vollständigen Periode der Grundfrequenz von 50 Hz erfolgt. Beispielsweise werden N2=600 erste Mittelwerte M1i für die Berechnung eines aktuellen zweiten Mittelwerts M20 verwendet. Die Recheneinrichtung MP zieht auch den aktuellen zweiten Mittelwert M20 jeweils vom aktuellen zweiten Summenwert S20 ab und bildet so jeweils einen aktuellen dritten Summenwert S30.

Die Offset-Stabilisierung OS und die erste und zweite Offset-Kompensation OC1, OC2 bilden eine primäre Offset-Kompensation POC.

Die zur Signalkonditionierung SC verwendete Software (Firmware) wird, bedingt durch die prinzipielle Arbeitsweise des Mikrocontrollers MC mit der Recheneinrichtung MP wie hier in Form eines Mikroprozessors, in Taktschritten abgearbeitet. Dadurch entsteht zwischen den Eingangswerten (U1ti, U1t0) und den Ausgangswerten (S3i, S30) der Signalkonditionierung SC ein (unvermeidlicher) zeitlicher Verzug.

Deshalb wird anschließend aus mehreren dritten zeitlich davor liegenden Summenwerten S3i und dem aktuellen dritten Summenwert S30 durch eine Vorhersage SF (Signal Forecast) in Form einer Extrapolation ein Vorhersagewert Vt1out für einen jeweils vorgegebenen Ausgabezeitpunkt t1out berechnet, der aufgrund des zeitlichen Verzugs in der Recheneinrichtung MP zeitlich hinter dem Zeitpunkt t0 liegt. Fortlaufend aufeinanderfolgend liegen dann die Vorhersagewerte Vtiout zu den Ausgabezeitpunkten tiout vor.

Im Falle von äquidistanten, fortlaufend aufeinanderfolgenden digitalen Zeitpunkten ti, wie hier im Ausführungsbeispiel, erfolgt die Extrapolation des Vorhersagewerts Vt1out zweckmäßigerweise jeweils für den Zeitpunkt t1 als Ausgabezeitpunkt t1out.

Beispielhaft wird in Fig. 3 aus einem oder mehreren dritten Summenwerten S3i und dem aktuellen dritten Summenwert S30 durch Extrapolation jeweils ein Vorhersagewert Vt1 für den Ausgabezeitpunkt t1 berechnet. Der Vorhersagewert Vt1out wird dadurch zu Vt1 und der Ausgabezeitpunkt t1out zum Ausgabezeitpunkt t1. Fortlaufend aufeinanderfolgend liegen dann die Vorhersagewerte Vti zu den Ausgabezeitpunkten ti vor.

Beispielsweise wird jeweils aus den beiden dritten Summenwerten S3-2 und S3-1, die unmittelbar vor dem aktuellen dritten Summenwert S30 liegen, die Differenz D=(S3-2)-(S3-1) gebildet, durch zwei geteilt (ergibt D/2) und die halbe Differenz D/2 zum aktuellen dritten Summenwert S30 addiert und so jeweils ein aktueller Vorhersagewert Vt1 gebildet.

Speziell wird jeweils aus einem dritten Summenwerte S3-1, der unmittelbar vor dem aktuellen dritten Summenwert S30 liegt, die Differenz D=(S3-1)-(S30) gebildet, durch zwei geteilt (ergibt D/2) und die halbe Differenz D/2 zum aktuellen dritten Summenwert S30 addiert und so jeweils ein aktueller Vorhersagewert Vt1 gebildet.

Wie in Fig. 3 weiter gezeigt, führt die Recheneinrichtung MP noch eine dritte Offset-Kompensation OC3 durch, um den Offset OFF2 des Operationsverstärkers OA2 zu kompensieren, indem sie die vom Spannungswandler VC pegelangepasste dritte analoge Wechselspannung Ua(t) mittels des AD-Wandlers ADC2 in fortlaufend aufeinanderfolgende zweite Spannungswerte U2ti umwandelt. Anhand der Spannungswerte U2ti berechnet die Recheneinrichtung MP jeweils einen gleitenden aktuellen dritten Mittelwert M30, und zwar aus einer festen dritten Anzahl N3 unmittelbar aufeinanderfolgender Spannungswerte U2ti. Die unmittelbar aufeinanderfolgenden Spannungswerte U2ti können den Spannungswert U2t0 einschließen. Die Recheneinrichtung MP zieht dann auch den aktuellen dritten Mittelwert M30 jeweils vom aktuellen Vorhersagewert Vt1 ab und bildet so jeweils einen offsetkorrigierten aktuellen Vorhersagewert Vt1c (und fortlaufend aufeinanderfolgend die Vorhersagewerte Vtic).

Um den Offset OFF2 des Operationsverstärkers OA2 zu kompensieren, kann im einfachsten Fall der aktuelle dritte Mittelwert M30 durch einen vorgegebenen und insbesondere konstanten Korrekturwert ersetzt und damit anstelle des Mittelwerts M30 verwendet werden, den man z.B. vor Beginn der Messungen ermittelt. Änderungen des Korrekturwerts im Verlauf der Zeit t lassen sich auf diese Weise aber nicht berücksichtigen.

Aufgrund der äquidistanten, fortlaufend aufeinanderfolgenden digitalen Zeitpunkte ti erfolgt die Ausgabe des so gebildeten Vorhersagewerts Vt1c an der Schnittstelle o3 jeweils zum nächstfolgenden Zeitpunkt t1 als vorgegebenem Ausgabezeitpunkt t1, zu dem der Wechselstrom I(t) aufgrund des Zeitverzugs durch die Recheneinrichtung MP bereits den Stromwert I(t1) angenommen hat, was aber durch die Berechnung des Vorhersagewerts Vt1, also durch die Vorausberechnung für den Zeitpunkt t1 bereits berücksichtigt ist. Mit anderen Worten: Der so gebildete Vorhersagewert Vt1c wird an der Schnittstelle o3 jeweils zum Zeitpunkt t1 als vorgegebener Ausgabezeitpunkt t1out ausgegeben.

Überraschenderweise führen die hier beispielhaft beschriebenen einfachen Extrapolationen bereits zu sehr geringen Laufzeitfehlern.

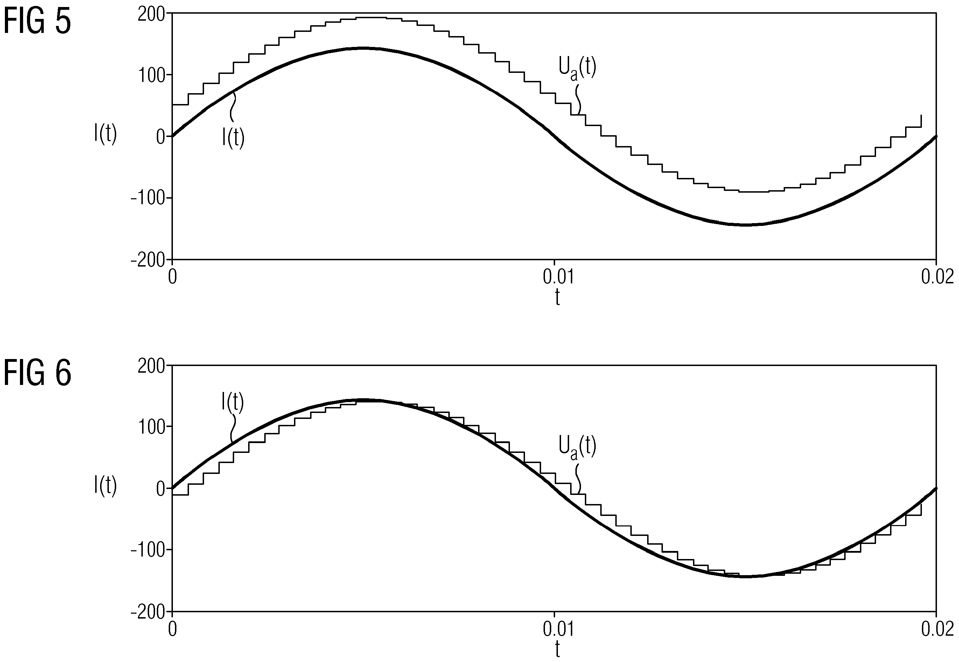

Fig. 5 zeigt den Verlauf des Wechselstroms I(t) und den treppenförmigen Verlauf der analogen Wechselspannung Ua(t) nur mit Offset-Stabilisierung OS und erster Offset-Kompensation OC1.

Fig. 6 zeigt den Verlauf des Wechselstroms I(t) und den treppenförmigen Verlauf der analogen Wechselspannung Ua(t) ohne Offset-Kompensation OC3, d.h. ohne Kompensation des Offsets OFF2 des Operationsverstärkers OA2.

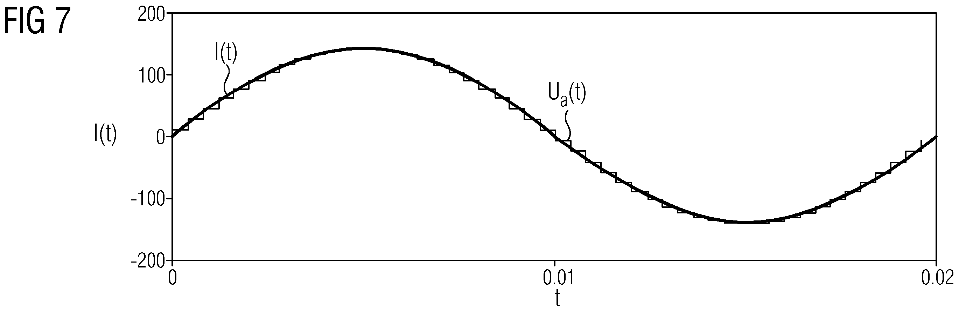

Fig. 7 zeigt den Verlauf des Wechselstroms I(t) und den treppenförmigen Verlauf der analogen Wechselspannung Ua(t) mit Offset-Stabilisierung OS, erster und zweiter Offset-Kompensation OC1, OC2 und mit Berechnung der Vorhersagewerte Vt1i. Man erkennt hier eine sehr gute Übereinstimmung der beiden zeitlichen Verläufe.

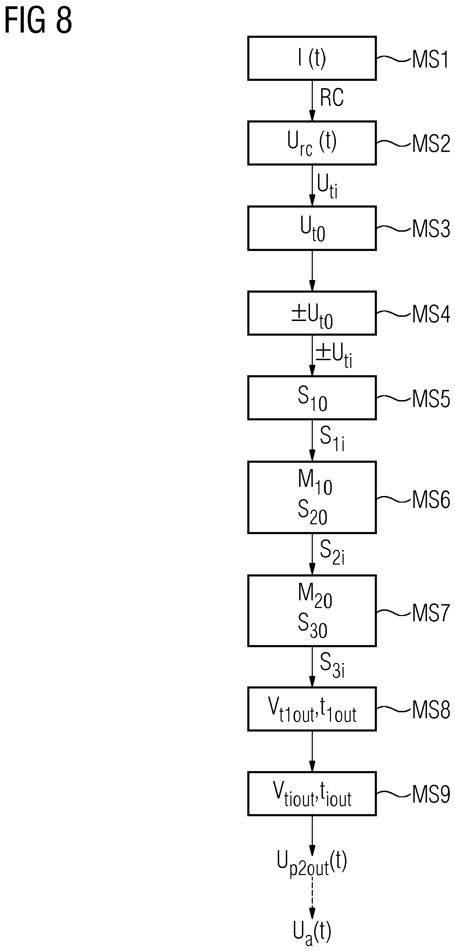

Fig. 8 zeigt zusammenfassend die Verfahrensschritte MS des Verfahrens zur Messung des Wechselstroms I(t):
MS1: Der zu messender Wechselstrom I(t), der periodisch kontinuierliche Stromwerte Iti durchläuft und zu einem Zeitpunkt t0 einen aktuellen Stromwert I(t0) annimmt, fließt durch den Strompfad, den die Rogowskispule RC vollständig umschließt.
MS2: Von der Rogowskispule RC wird jeweils eine korrespondierende erste analoge Wechselspannung Urc(t) erzeugt.
MS3: Die erste analoge Wechselspannung Urc(t) wird in korrespondierende digitale Spannungswerte Uti umgewandelt, die zeitlich fortlaufend aufeinanderfolgen, und der zum Zeitpunkt t0 gehörende digitale Spannungswert wird als aktueller erster Spannungswert Ut0 ausgegeben.
MS4: Der aktuelle erste Spannungswert Ut0 wird jeweils entsprechend dem Vorzeichen der ersten analogen Wechselspannung Urc(t) entweder mit einem positiven oder einem negativen Vorzeichen versehen.
MS5: Der aktuelle erste Spannungswert Ut0 wird jeweils zu einem ersten Summenwert Sli hinzuaddiert und so jeweils ein aktueller erster Summenwert S10 gebildet.
MS6: Aus den fortlaufend aufeinanderfolgenden ersten Summenwerten Sli wird jeweils ein aktueller gleitender erster Mittelwert M10 gebildet, dieser vom aktuellen ersten Summenwert S10 abgezogen und so ein aktueller zweiter Summenwert S20 gebildet.
MS7: Aus den fortlaufend aufeinanderfolgenden zweiten Summenwerten S2i wird jeweils ein aktueller gleitender zweiter Mittelwert M20 gebildet, dieser vom aktuellen zweiten Summenwert S20 abgezogen und so ein aktueller dritter Summenwert S30 gebildet.
MS8: Mehrere dritte Summenwerte S3i werden verwendet, um durch Extrapolation einen aktuellen Vorhersagewert Vt1out für einen vorgegebenen Ausgabezeitpunkt t1out zu berechnen, der zeitlich hinter dem Zeitpunkt t0 liegt.
MS9: Der aktuelle Vorhersagewert Vt1out wird jeweils zu dem vorgegebenen Ausgabezeitpunkt t1out ausgegeben und aus den fortlaufend aufeinanderfolgenden Vorhersagewerten Vtiout zu den zugehörigen fortlaufend aufeinanderfolgenden Ausgabezeitpunkten tiout wird eine zweite analoge Wechselspannung Up2out(t) gebildet.

## Patentansprüche

1. Verfahren zur Messung eines Wechselstroms (I(t)) mittels einer Rogowskispule (RC), die einen Strompfad umschließt, durch den der zu messende Wechselstrom (I(t)) fließt, der periodisch kontinuierliche Stromwerte (I(ti)) durchläuft und zu einem ersten Zeitpunkt (t0) einen aktuellen Stromwert (I(t0)) annimmt,
bei dem die Rogowskispule (RC) jeweils eine korrespondierende erste analoge Wechselspannung (Urc(t)) erzeugt,
bei dem die erste analoge Wechselspannung (Urc(t)) in korrespondierende digitale Spannungswerte (Uti) umgewandelt wird, die zeitlich fortlaufend aufeinanderfolgen, wobei der zum ersten Zeitpunkt (t0) gehörende digitale Spannungswert (Uti) als aktueller erster Spannungswert (Ut0) ausgegeben wird,
und bei dem der aktuelle erste Spannungswert (Ut0) jeweils entsprechend dem Vorzeichen der ersten analogen Wechselspannung (Urc(t)) entweder mit einem positiven oder einem negativen Vorzeichen versehen wird,
**dadurch gekennzeichnet,**
**dass** der aktuelle erste Spannungswert (Ut0) jeweils zu einem ersten Summenwert (S1i) hinzuaddiert und so jeweils ein aktueller erster Summenwert (S10) gebildet wird,
**dass** jeweils aus den fortlaufend aufeinanderfolgenden ersten Summenwerten (S1i) ein aktueller erster Mittelwert (M10) gebildet, dieser vom aktuellen ersten Summenwert (S10) abgezogen und so ein aktueller zweiter Summenwert (S20) gebildet wird,
**dass** jeweils aus den fortlaufend aufeinanderfolgenden zweiten Summenwerten (S2i) ein aktueller zweiter Mittelwert (M20) gebildet, dieser vom aktuellen zweiten Summenwert (S20) abgezogen und so ein aktueller dritter Summenwert (S30) gebildet wird,
**dass** mehrere dritte Summenwerte (S3i) verwendet werden, um durch Extrapolation einen Vorhersagewert (Vt1out) für einen vorgegebenen Ausgabezeitpunkt (tlout) zu berechnen, der zeitlich nächstfolgend hinter dem ersten Zeitpunkt (t0) liegt, und
**dass** der Vorhersagewert (Vt1out) jeweils zu dem vorgegebenen Ausgabezeitpunkt (tlout) ausgegeben und aus den fortlaufend aufeinanderfolgenden Vorhersagewerten (Vtiout) zu den zugehörigen fortlaufend aufeinanderfolgenden Ausgabezeitpunkten (tiout) eine zweite analoge Wechselspannung (Up2out(t)) gebildet wird.

2. Verfahren nach Anspruch 1,
**dadurch gekennzeichnet,**
**dass** der aktuelle Vorhersagewert (Vt1out) anhand der Änderung des aktuellen dritten Summenwerts (S30) gegenüber dem unmittelbar vorhergehenden dritten Summenwert (S3-1) und dem aktuellen dritten Summenwert (S30) berechnet wird.

3. Verfahren nach Anspruch 2,
**dadurch gekennzeichnet,**
**dass** der aktuelle Vorhersagewert (Vt1out) berechnet wird, indem die Änderung des aktuellen dritten Summenwerts (S30) gegenüber dem unmittelbar vorhergehenden dritten Summenwert (S3-1) anteilig zum berechneten aktuellen dritten Summenwert (S30) hinzuaddiert wird.

4. Verfahren nach einem der Ansprüche 1 - 3,
**dadurch gekennzeichnet,**
**dass** die zweite analoge Wechselspannung (Up2out(t)) verstärkt und so eine dritte analoge Wechselspannung (Ua(t)) gebildet wird und dass durch eine entsprechende Korrektur ein Offset (OFF2) der dritten analogen Wechselspannung (Ua(t)) durch eine entsprechende Korrektur des jeweils aktuellen Vorhersagewerts (Vt1out) berücksichtigt wird.

5. Verfahren nach einem der Ansprüche 1 - 4,
**dadurch gekennzeichnet,**
**dass** die dritte analoge Wechselspannung (Ua(t)) digitalisiert und ein dritter Mittelwert (M30) als Offset der dritten analogen Wechselspannung (Ua(t)) berechnet und für eine entsprechende Korrektur des jeweils aktuellen Vorhersagewerts (Vt1out) verwendet wird.

6. Verfahren nach einem der Ansprüche 1 - 5,
**dadurch gekennzeichnet,**
**dass** der dritte Mittelwert (M30) als gleitender dritter Mittelwert (M30) berechnet wird.

7. Einrichtung (MD) zur Messung eines Wechselstroms (I(t)) mit einer Rogowskispule (RC), die einen Strompfad umschließt, durch den der Wechselstrom (I(t)) fließt, der periodisch kontinuierliche Stromwerte (I(ti)) durchläuft und zu einem ersten Zeitpunkt (t0) einen aktuellen Stromwert annimmt (I(t0)), wobei die Rogowskispule (RC) eine erste analoge Wechselspannung (Urc(t)) erzeugt,
mit einem ersten AD-Wandler (AD1), der die erste analoge Wechselspannung (Urc(t)) in korrespondierende digitale Spannungswerte (U1ti) umwandelt, die zeitlich fortlaufend aufeinanderfolgen, wobei der zum ersten Zeitpunkt (t0) gehörende digitale Spannungswert als aktueller erster Spannungswert (U1t0) am Ausgang des ersten AD-Wandlers (AD1) anliegt mit einer Recheneinrichtung (MP),
welche den aktuellen ersten Spannungswert (U1t0) jeweils entsprechend dem Vorzeichen der ersten analogen Wechselspannung (Urc(t)) entweder mit einem positiven oder einem negativen Vorzeichen versieht, wobei die Einrichtung (MD) ist **dadurch gekennzeichnet, dass** die Recheneinrichtung (MP)
den vorzeichenbehafteten aktuellen ersten Spannungswert (U1t0) jeweils zu einem ersten Summenwert (S1i) hinzuaddiert und so jeweils einen aktuellen ersten Summenwert (S10) bildet,
aus den fortlaufend aufeinanderfolgend gebildeten ersten Summenwerten (S1i) einen aktuellen ersten Mittelwert (M10) bildet, diesen jeweils vom aktuellen ersten Summenwert (S10) abzieht und so jeweils einen aktuellen zweiten Summenwert (S20) bildet,
aus den fortlaufend aufeinanderfolgend gebildeten zweiten Summenwerten (S2i) einen aktuellen zweiten Mittelwert (M20) bildet, diesen jeweils vom aktuellen zweiten Summenwert (S20) abzieht und so jeweils einen aktuellen dritten Summenwert (S30) bildet,
aus einem oder mehreren dritten Summenwerten (S3i) einen Vorhersagewert (Vt1out) durch Extrapolation für einen vorgegebenen Ausgabezeitpunkt (tlout) berechnet, der zeitlich hinter dem ersten Zeitpunkt (t0) liegt, und
mit einem DA-Wandler (DAC), der den Vorhersagewert (Vt1out) zu dem vorgegebenen Ausgabezeitpunkt (tlout) ausgibt und dabei aus den fortlaufend aufeinanderfolgenden Vorhersagewerten (Vtiout) zu den zugehörigen fortlaufend aufeinanderfolgenden Ausgabezeitpunkten (tiout) eine zweite analoge Wechselspannung (Up2out(t)) bildet.

8. Einrichtung nach Anspruch 7,
**dadurch gekennzeichnet,**
**dass** ein zweiter Verstärker (OA2) vorhanden ist, der an den DA-Wandler (DAC) angeschlossen ist, und dass die Recheneinrichtung (MP) im Falle eines vom zweiten Verstärker (OA2) verursachten Offsets (OFF2) diesen Offset (OFF2) jeweils vom aktuellen Vorhersagewert (Vt1out) abzieht.

9. Einrichtung nach Anspruch 8,
**dadurch gekennzeichnet,**
**dass** eine Rückführung (R) vom zweiten Verstärker (OA2) über, einen zweiten AD-Wandler (ADC2) vorhanden ist, der zur Korrektur des Offsets (OFF2) des zweiten Verstärkers (OA2) an die Recheneinrichtung (MP) angeschlossen ist.

10. Einrichtung nach Anspruch 9,
**dadurch gekennzeichnet,**
**dass** der zweite AD-Wandler (ADC2) korrespondierende digitale zweite Spannungswerte (U2ti) der Recheneinrichtung (MP) zur Verfügung stellt, die fortlaufend aufeinanderfolgende zweite Spannungswerte (U2ti) bilden, aus denen die Recheneinrichtung (MP) einen gleitenden dritten Mittelwert (M30) als Offset (OFF2) des zweiten Verstärkers (OA2) berechnet, welchen die Recheneinrichtung (MP) jeweils für eine Korrektur des aktuellen Vorhersagewerts (Vt1out) verwendet.

## Claims

1. Method for measuring an AC current (I(t)) by means of a Rogowski coil (RC) that encloses a current path through which the AC current (I(t)) to be measured flows, said current periodically passing through continuous current values (I(ti)) and assuming a present current value (I(t0)) at a first time (t0),
in which the Rogowski coil (RC) in each case generates a corresponding first analogue AC voltage (Urc(t)),
in which the first analogue AC voltage (Urc(t)) is converted into corresponding digital voltage values (Uti) that are continuously successive in time, wherein the digital voltage value (Uti) belonging to the first time (t0)is output as the present first voltage value (Ut0),
and in which the present first voltage value (Ut0) is provided with either a positive or a negative arithmetic sign in each case according to the arithmetic sign of the first analogue AC voltage (Urc(t)),
**characterized**
**in that** the present first voltage value (Ut0) is added to a first sum value (S1i) in each case and a present first sum value (S10) is therefore formed in each case,
**in that** a present first mean value (M10) is formed in each case from the continuously successive first sum values (S1i) and is subtracted from the present first sum value (S10), and a present second sum value (S20) is therefore formed,
**in that** a present second mean value (M20) is formed in each case from the continuously successive second sum values (S2i) and is subtracted from the present second sum value (S20), and a present third sum value (S30) is therefore formed,
**in that** multiple third sum values (S3i) are used to calculate, through extrapolation, a prediction value (Vt1out) for a predefined output time (tlout) that is soonest after the first time (t0),
and
**in that** the prediction value (Vt1out) is output at the predefined output time (t1out) in each case and a second analogue AC voltage (Up2out(t)) is formed from the continuously successive prediction values (Vtiout) at the associated continuously successive output times (tiout).

2. Method according to Claim 1,
**characterized**
**in that** the present prediction value (Vt1out) is calculated on the basis of the change in the present third sum value (S30) compared to the directly preceding third sum value (S3-1) and the present third sum value (S30).

3. Method according to Claim 2,
**characterized**
**in that** the present prediction value (Vt1out) is calculated by virtue of the change in the present third sum value (S30) compared to the directly preceding third sum value (S3-1) being added proportionately to the calculated present third sum value (S30).

4. Method according to one of Claims 1 to 3,
**characterized**
**in that** the second analogue AC voltage (Up2out(t)) is amplified and a third analogue AC voltage (Ua(t)) is therefore formed, and in that an appropriate correction takes into account an offset (OFF2) of the third analogue AC voltage (Ua(t)) by means of an appropriate correction of the respective present prediction value (Vt1out).

5. Method according to one of Claims 1 to 4,
**characterized**
**in that** the third analogue AC voltage (Ua(t)) is digitized and a third mean value (M30) is calculated as the offset of the third analogue AC voltage (Ua(t)) and is used for an appropriate correction of the respective present prediction value (Vt1out).

6. Method according to one of Claims 1 to 5,
**characterized**
**in that** the third mean value (M30) is calculated as a moving third mean value (M30).

7. Device (MD) for measuring an AC current (I(t)) having a Rogowski coil (RC) that encloses a current path through which the AC current (I(t)) flows, said current periodically passing through continuous current values (I(ti)) and assuming a present current value (I(t0)) at a first time (t0),
wherein the Rogowski coil (RC) generates a first analogue AC voltage (Urc(t)),
having a first AD converter (AD1) that converts the first analogue AC voltage (Urc(t)) into corresponding digital voltage values (U1ti) that are continuously successive in time, wherein the digital voltage value belonging to the first time (t0) is applied as the present first voltage value (U1t0) to the output of the first AD converter (AD1),
having a computing device (MP) that provides the present first voltage value (U1t0) with either a positive or a negative arithmetic sign in each case according to the arithmetic sign of the first analogue AC voltage (Urc(t)), wherein the device (MD) is **characterized in that** the computing device (MP) adds the arithmetically signed present first voltage value (U1t0) to a first sum value (S1i) in each case and therefore forms a present first sum value (S10) in each case,
forms a present first mean value (M10) from the continuously successively formed first sum values (S1i), subtracts said mean value from the present first sum value (S10) in each case, and therefore forms a present second sum value (S20) in each case,
forms a present second mean value (M20) from the continuously successively formed second sum values (S2i), subtracts said mean value from the present second sum value (S20) in each case, and therefore forms a present third sum value (S30) in each case,
calculates, from one or more third sum values (S3i), through extrapolation, a prediction value (Vt1out) for a predefined output time (tlout) that is later than the first time (t0), and
having a DA converter (DAC) that outputs the prediction value (Vt1out) at the predefined output time (tlout) and in the process forms a second analogue AC voltage (Up2out(t)) from the continuously successive prediction values (Vtiout) at the associated continuously successive output times (tiout).

8. Device according to Claim 7,
**characterized**
**in that** there is a second amplifier (OA2) that is connected to the DA converter (DAC), and in that in the event of an offset (OFF2) caused by the second amplifier (OA2) the computing device (MP) subtracts this offset (OFF2) from the present prediction value (Vt1out) in each case.

9. Device according to Claim 8,
**characterized**
**in that** there is feedback (R) from the second amplifier (OA2) via a second AD converter (ADC2) that is connected to the computing device (MP) to correct the offset (OFF2) of the second amplifier (OA2).

10. Device according to Claim 9,
**characterized**
**in that** the second AD converter (ADC2) provides the computing device (MP) with corresponding digital second voltage values (U2ti) that form continuously successive second voltage values (U2ti) from which the computing device (MP) calculates a moving third mean value (M30) as the offset (OFF2) of the second amplifier (OA2), which the computing device (MP) uses in each case for a correction of the present prediction value (Vt1out) .

## Revendications

1. Procédé de mesure d'un courant (I(t)) alternatif au moyen d'une bobine (RC) de Rogowski, qui enferme un trajet de courant, par lequel passe le courant (I(t)) alternatif à mesurer qui passe périodiquement à des valeurs (I(ti)) continues de courant et qui prend à un premier instant (t0)une valeur (I(t0)) instantanée de courant,
dans lequel la bobine (RC) de Rogowski produit respectivement une première tension (Urc(t)) alternative analogique correspondante, dans lequel on transforme la première tension (Urc(t)) alternative analogique en des valeurs (Uti) de tension numériques correspondantes qui se succèdent continuellement dans le temps, dans lequel on se donne la valeur (Uti) de tension numérique appartenant au premier instant (t0) comme première valeur (Ut0) de tension instantanée et dans lequel on munit la première valeur (Ut0) de tension instantanée respectivement en correspondance avec le signe de la première tension (Urc(t)) alternative analogique d'un signe positif ou négatif,
**caractérisé**
**en ce que** l'on ajoute la première valeur (Ut0) de tension instantanée respectivement à une première valeur (S1i) de somme et on forme ainsi respectivement une première valeur (S10) de somme instantanée,
**en ce que** respectivement, à partir des premières valeurs (S1i) de somme successives en continu, on forme une première valeur (M10) moyenne instantanée, on la soustrait de la première valeur (S10) somme instantanée et on forme ainsi une deuxième valeur (S20) somme instantanée,
**en ce que** respectivement à partir des deuxièmes valeurs (S2i) somme successives en continu, on forme une deuxième valeur (M20) moyenne instantanée, on la soustrait de la deuxième valeur (S20) somme instantanée et on forme ainsi une troisième valeur (S30) somme instantanée,
**en ce que** l'on utilise plusieurs troisièmes valeurs (S3i) somme pour calculer par extrapolation une valeur (Vt1out) de prédiction d'un instant (tlout) de sortie donné à l'avance qui, dans le temps, vient immédiatement après le premier instant (t0), et
**en ce que** l'on sort la valeur (Vt1out) de prédiction respectivement à l'instant (tlout) de sortie donné à l'avance et à partir des valeurs (Vtiout) de prédiction successives en continu aux instants (tiout) de sortie successifs en continu associés, on forme une deuxième tension (Up2out(t)) alternative analogique.

2. Procédé suivant la revendication 1,
**caractérisé**
**en ce que** l'on calcule la valeur (Vt1out) de prédiction instantanée à l'aide de la variation de la troisième valeur (S30) somme instantanée par rapport à la troisième valeur (S3-1) somme immédiatement précédente et de la troisième valeur (S30) somme instantanée.

3. Procédé suivant la revendication 2,
**caractérisé**
**en ce que** l'on calcule la valeur (Vt1out) de prédiction instantanée en additionnant la variation de la troisième valeur (S30) somme instantanée par rapport à la troisième valeur (S3-1) somme immédiatement précédente proportionnellement à la troisième valeur (S30) somme instantanée calculée.

4. Procédé suivant l'une des revendications 1 à 3,
**caractérisé**
**en ce que** l'on amplifie la deuxième tension (Up2out(t)) alternative analogique et on forme ainsi une troisième tension (Ua(t)) alternative analogique et en ce que, par une correction correspondante, on tient compte d'un décalage (OFF2) de la troisième tension (Ua(t)) alternative analogique par une correction correspondante de la valeur (Vt1out) de prédiction instantanée respective.

5. Procédé suivant l'une des revendications 1 à 4,
**caractérisé**
**en ce que** l'on numérise la troisième tension (Ua(t)) alternative analogique et on calcule une troisième valeur (M30) moyenne comme décalage de la troisième tension (Ua(t)) alternative analogique et on l'utilise pour une correction correspondante de la valeur (Vt1out) de prédiction instantanée respective.

6. Procédé suivant l'une des revendications 1 à 5,
**caractérisé**
**en ce que** l'on calcule la troisième valeur (M30) moyenne sous la forme d'une troisième valeur (M30) moyenne glissante.

7. Dispositif (MD) de mesure d'un courant (I(t)) alternatif, comprenant une bobine (RC) de Rogowski qui enferme un trajet de courant, dans lequel passe le courant (I(t)) alternatif qui passe périodiquement par des valeurs (I(ti)) continues de courant et prend à un premier instant (t0) une valeur (I(t0)) instantanée de courant, la bobine (RC) de Rogowski produisant une première tension (Urc(t)) alternative analogique,
comprenant un premier convertisseur (AD1) analogique-numérique, qui transforme la première tension (Urc(t)) alternative analogique en des valeurs (U1ti) de tension numériques correspondantes qui se succèdent en continu dans le temps, dans lequel la valeur de tension numérique appartenant au premier instant (t0) s'applique comme première valeur (U1t0) de tension instantanée à la sortie du premier convertisseur (AD1) analogique-numérique,
comprenant un dispositif (MP) informatique, qui munit la première valeur (U1t0) de tension instantanée respectivement conformément au signe de la première tension (Urc(t)) alternative analogique d'un signe positif ou négatif, le dispositif (MD) étant **caractérisé en ce que** le dispositif (MP) informatique ajoute la première valeur (U1t0) de tension instantanée munie d'un signe respectivement à une première valeur (S1i) de somme et forme ainsi respectivement une première valeur (S10) de somme instantanée,
à partir des premières valeurs (S1i) de somme formées successivement en continu forme une première valeur (M10) moyenne instantanée, la soustrait respectivement de la première valeur (S10) de somme instantanée et forme ainsi respectivement une deuxième valeur (S20) de somme instantanée,
à partir des deuxièmes valeurs (S2i) de somme formées successivement en continu, forme une deuxième valeur (M20) moyenne instantanée, la soustrait respectivement de la deuxième valeur (S20) de somme instantanée et forme ainsi respectivement une troisième valeur (S30) de somme instantanée,
à partir d'une ou de plusieurs troisièmes valeurs (S3i) de somme, calcule une valeur (Vt1out) de prédiction par extrapolation pour un instant (tlout) de sortie donné à l'avance qui, dans le temps, est postérieur au premier instant (t0), et comprenant un convertisseur (DAC) numérique-analogique, qui sort la valeur (Vt1out) de prédiction à l'instant (tlout) de sortie donné à l'avance et forme ainsi, à partir des valeurs (Vtiout) de prédiction successives en continu aux instants (tiout) de sortie successifs en continu associés, une deuxième tension (Up2out(t)) alternative analogique.

8. Dispositif suivant la revendication 7,
**caractérisé**
**en ce qu'**il y a un deuxième amplificateur (OA2), qui est connecté au convertisseur (DAC) numérique-analogique et en ce que le dispositif (MP) informatique soustrait, dans le cas d'un décalage (OFF2), provoqué par le deuxième amplificateur (OA2), ce décalage (OFF2) respectivement de la valeur (Vt1out) de prédiction instantanée.

9. Dispositif suivant la revendication 8,
**caractérisé**
**en ce qu'**il y a un retour (R) du deuxième amplificateur (OA2) par un deuxième convertisseur (ADC2) analogique-numérique qui, pour la correction du décalage (OFF2) du deuxième amplificateur (OA2) est connecté au dispositif (MP) informatique.

10. Dispositif suivant la revendication 9,
**caractérisé**
**en ce que** le deuxième convertisseur (ADC2) analogique-numérique met à disposition du dispositif (MP) informatique des deuxièmes valeurs (U2ti) de tension numériques correspondantes, qui forment des deuxièmes valeurs (U2ti) de tension successives en continu, à partir desquelles le dispositif (MP) informatique calcule une troisième valeur (M30) moyenne glissante comme décalage (OFF2) du deuxième amplificateur (OA2), que le dispositif (MP) informatique utilise respectivement pour une correction de la valeur (Vt1out) de prédiction instantanée.
